# EUROPEAN PATENT APPLICATION

(11) **EP 1 482 568 A2**
(43) Date of publication of application: **01.12.2004**
(21) Application number: 04012367.1
(22) Date of filing: 25.05.2004
(51) Int. Cl.: H01L 35/00, H01L 35/30

(54) **Thermoelectric energy conversion unit and tunnel-type furnace therewith**

(30) Priority: 26.05.2003 JP 2003148148
(71) Applicant: Hitachi Powdered Metals Co., Ltd., Matsudo-shi, Chiba 270-2295 (JP); Central Research Institute of Electric Power Industry, Tokyo 100-8126 (JP)
(72) Inventor: Shikata, Hideo, Matsudo-shi Chiba 270-2295 (JP); Kambe, Mitsuru, Chiyoda-ku Tokyo 100-8126 (JP)
(74) Representative: Eisenführ, Speiser & Partner

(57) **Abstract**

A thermoelectric energy conversion unit includes: a thermoelectric conversion module having plural thermoelectric conversion elements disposed away from each other; a heat receiving member; a cooling member, the cooling member and the heat receiving member holding the thermoelectric conversion module; and a non-oxidizing gas charged in a space formed between the heat receiving member and the cooling member.

## Description

### BACKGROUND OF THE INVENTION

### 1. Field of the Invention

The present invention relates to thermoelectric energy conversion units using the Seebeck effect which convert heat energy to electric energy, and relates to tunnel-type furnaces therewith. In particular, the present invention relates to a tunnel-type furnace which provides good thermal efficiency, facilitates the maintenance thereof, and has long-term stable performance.

### 2. Description of the Related Art

Direct generation systems generate electricity by using thermoelectric conversion modules having thermoelectric conversion elements. The direct generation systems are simply constructed and do not have moving portions, thereby having high reliability and facilitating maintenance thereof. However, the direct generation systems have low output density and low energy conversion efficiency. Due to this, research has been performed only on apparatuses for the direct generation systems for special use which have low output scale, such as for spacecraft. However, direct generation systems are recently anticipated to be applied to generation systems using waste heat generated from refuse incinerators in order to conserve resources. As a result, the reduction of the generation cost, the durability of the thermoelectric conversion modules, etc., may be favorably improved.

The above thermoelectric conversion modules can be applied to endless belt-type furnaces, pusher-type furnaces for powder metallurgy, or furnaces for ceramics heated in air atmospheres, etc. These furnaces are referred to as "tunnel-type furnaces" hereinafter. Specifically, thermoelectric conversion modules can generate electricity by using the waste heat generated from the tunnel-type furnaces, and the generated electricity can be used for operations of electric furnaces. A technique having the thermoelectric conversion modules is disclosed in, for example, Japanese Unexamined Patent Application Publication No. 2002-171776 as described below. That is, a thermoelectric generation device for industrial furnaces is constructed such that a thermoelectric conversion module provided with a ceramic and a graphite is provided at the inside faces of a temperature raising zone, a heating zone, and a cooling zone of endless belt-type continuous furnaces.

However, in the technique in the above Japanese Unexamined Patent Application Publication No. 2002-171776, when a thermoelectric conversion module is provided in the temperature raising zone or the heating zone, heat loss occurs due to a cooling device cooling the thermoelectric conversion module, and good thermal efficiency cannot be obtained overall. In the above technique, since the thermoelectric conversion module is provided at the inner face of the furnace, it is difficult to perform maintenance thereon, and repair work on the thermoelectric conversion module cannot be performed during the operation of the furnace. The above technique employs a construction such that the thermoelectric conversion module is suspended from the wall of the furnace. Since the suspended structure and the insufficiency of the heat stress relieving device among each member of the thermoelectric conversion module are coupled, the thermoelectric conversion module may possibly peel off and fall therefrom. The thermoelectric conversion module is in an oxidizing atmosphere, and it is thereby oxidized and functions deteriorate. Due to this, the furnace cannot have long-term stable performance.

### SUMMARY OF THE INVENTION

Objects of the present invention are to provide a thermoelectric energy conversion unit which has good thermal efficiency and to provide a tunnel-type furnace, having the thermoelectric energy conversion unit, which facilitates the maintenance thereof and has long-term stable performance.

The present invention provides a thermoelectric energy conversion unit comprising: a thermoelectric conversion module having plural thermoelectric conversion elements disposed away from each other; a heat receiving member; a cooling member, the cooling member and the heat receiving member holding the thermoelectric conversion module; and a non-oxidizing gas charged in a space formed between the heat receiving member and the cooling member.

According to the thermoelectric energy conversion unit of the present invention, since the non-oxidizing gas is charged in the space formed between the heat receiving member and the cooling member, the thermoelectric energy conversion unit is not oxidized, thereby being prevented from functionally deteriorating. Since the thermoelectric energy conversion unit has the above structure, the thermoelectric energy conversion unit is easily provided not only to new equipment but also to conventional equipment. In this case, when binders are filled in gaps formed between the thermoelectric energy conversion unit and the other members of the above equipment, the thermal conductivity thereof can be further improved so that generation performance is improved.

For example, the thermoelectric conversion module may be constructed such that plural thermoelectric elements, which are connected to each other by connecting pads, are disposed between copper plates so as to form an approximate square of 25 mm X 25 mm. The connecting pad may be the following multi-layered structural member. That is, an electrical insulator is disposed between copper plates having good electrical conductivity and thermal conductivity, and mixed middle layers are provided between the electrical insulator and the copper plates so as to relieve the difference in thermal stress which results from the difference in the coefficients of thermal expansion thereof. The connecting pad may have an overall good thermal conductivity, an electrical connection function among the thermoelectric conversion elements, an electrical insulation portion of a heat receiving side and a heat discharging side thereof, a temperature gradient therebetween, and a stress relieving function based on the thermal expansion difference between the copper plate and the electrical insulator. The component members of the connecting pad can be integrally or separately produced by using a powder metallurgy method.

The present invention provides a tunnel-type furnace including: a heating zone; a cooling zone, wherein heated bodies are transferred in turn in the heating zone and the cooling zone; and the above thermoelectric energy conversion unit provided between the heating zone and the cooling zone.

According to the tunnel-type furnace of the present invention, for example, bricks, etc., are provided to the heating zone so that the heating zone is thermally insulated, and a generation portion is provided between the heating zone and the cooling zone, whereby the thermoelectric conversion module can have good thermal efficiency. Since the above thermoelectric conversion module is used in the tunnel-type furnace of the present invention, for example, the above thermoelectric conversion module can be provided to the outer face of the tunnel-type furnace, and the tunnel-type furnace thereby facilitates the maintenance thereof. In the tunnel-type furnace of the present invention, the thermoelectric conversion modules can be provided to the outer face of the tunnel-type furnace, and thermal stress relieving members can be used as a component member of the thermoelectric conversion module. For example, the thermal stress relieving member may be a mixed material having a predetermined mixing ratio of respective components. As a result, the thermoelectric conversion module can be prevented from peeling off and falling from the tunnel-type furnace during the operation of the tunnel-type furnace. Since the non-oxidizing gas is charged in the space, there is no possibility that the thermoelectric conversion module will be oxidized and will be deteriorated during the operation of the tunnel-type furnace. Therefore, the tunnel-type furnace can have long-term stable performance.

### BRIEF DESCRIPTION OF THE DRAWINGS

Fig. 1 is a cross sectional view showing a general structure of a conventional mesh belt-type furnace;
Fig. 2 is a cross sectional view showing a general structure of a mesh belt-type furnace in one embodiment according to the present invention;
Fig. 3 is a cross sectional view showing another general structure of a mesh belt-type furnace in one embodiment according to the present invention;
Figs. 4A and 4B are cross sectional views showing a thermoelectric conversion module in one embodiment according to the present invention;
Figs. 5A to 5D are cross sectional views showing a desirable form of a thermoelectric conversion module in one embodiment according to the present invention;
Figs. 6A and 6B are upper face views showing an example of a connecting line of thermoelectric conversion modules shown in Figs. 5A to 5D;
Fig. 7 is a cross sectional view showing an example of a generation zone of the tunnel-type furnace;
Fig. 8 is an axial sectional view of the generation zone shown in Fig. 7;
Fig. 9 is a cross sectional view showing another example of a generation zone of the tunnel-type furnace;
Fig. 10 is a cross sectional view showing another example of a generation zone of the tunnel-type furnace;
Fig. 11 is a cross sectional view showing a structure for outputting electricity generated in the generation zone shown in Figs. 7 to 10;
Fig. 12 is a cross sectional view showing another example of a generation zone of the tunnel-type furnace;
Fig. 13 is a cross sectional view showing another example of a generation zone of the tunnel-type furnace;
Fig. 14 is an axial sectional view showing a connected form of the generation zone shown in Fig. 12 and 13;
Figs. 15A and 15B are cross sectional views showing a part of the connected form of the generation zone shown in Fig. 14;
Fig. 16 is a cross sectional view showing another example of a generation zone of the tunnel-type furnace; and
Fig. 17 is a cross sectional view showing details of a mounted structure of respective members shown in Fig.16.

### DESCRIPTION OF THE PREFERRED EMBODIMENTS

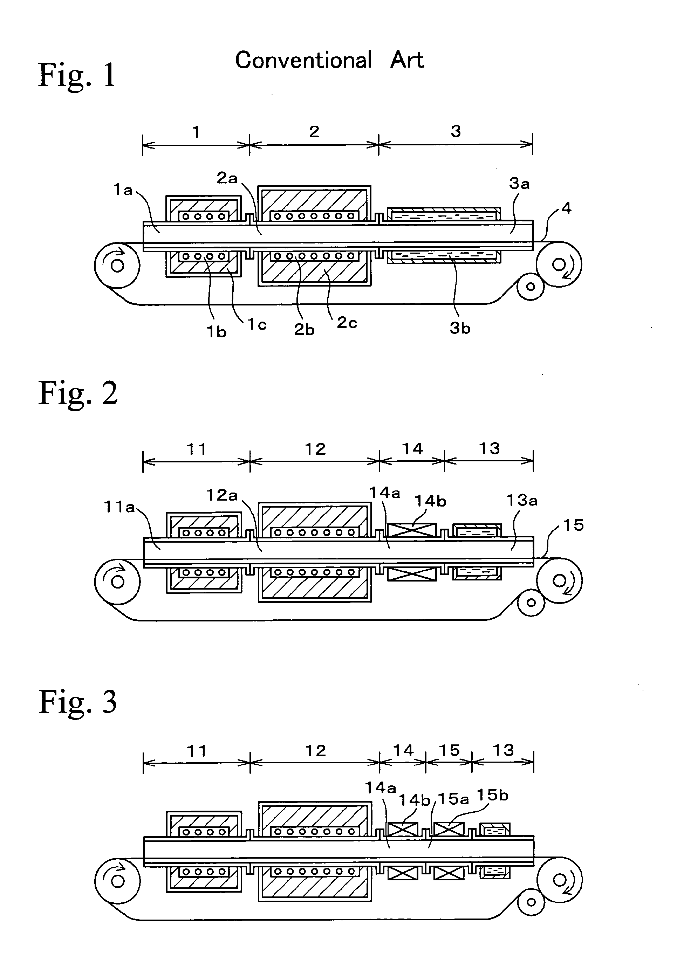

One embodiment of the present invention will be described hereinafter with reference to the Figures. Fig. 1 is a cross sectional view showing a general structure of a conventional mesh belt-type furnace (tunnel-type furnace). The furnace shown in Fig. 1 is divided into three units, that is, a preheating zone 1, a heating zone 2, and a cooling zone 3. An inner tube 1a in the pre-heating zone 1, an inner tube 2a in the heating zone 2, and an inner tube 3a in the cooling zone 3 are joined with each other. An endless belt 4 is continuously passed through the inner tubes 1a, 2a, and 3a.

In the pre-heating zone 1, a heater 1b is mounted around the inner tube 1a, and heat resisting bricks 1c are packed around the outside of the heater 1b. In the heating zone 2, a heater 2b is mounted around the inner tube 2a, and heat resisting bricks 2c are packed around the outside of the heater 2b. In the cooling zone 3, a water jacket 3b is mounted around the inner tube 3a. The heater 1b and 2b are of the electric heating types. A reducing gas is in the inner tubes 1a to 3a. For example, the reducing gas is a hydrogen gas or a mixed gas of a hydrogen gas and a nitrogen gas.

When the above furnace is used, the temperature of the heating zone 2 is set as follows. That is, when the heating zone 2 is used for sintering an iron-type alloy, the temperature thereof is set from 1100°C to 1200°C. When the heating zone 2 is for sintering a copper alloy, the temperature thereof is set from 750°C to 780°C. The furnace surface temperature of the preheating zone 1 and the heating zone 2 is about 500°C. When the sintered work holding heat on the endless belt 4 is moved to the cooling zone 3, the sintered work is cooled by the water jacket 3b so as to prevent oxidation, and the sintered work is removed therefrom. The cooling water is supplied to the water jacket 3b at any time, and the heated water is led to a pool, etc., so as to discharge heat in the air. Alternatively, the cooling water is cooled by a cooling device and is recycled. Thermoelectric conversion modules of the present invention are not provided in the tunnel-type furnace shown in Fig. 1.

Fig. 2 is a cross sectional view showing a general structure of a mesh belt-type furnace in one embodiment according to the present invention. The mesh belt-type furnace in Fig. 2 is divided into four units, that is, a preheating zone 11, a heating zone 12, a cooling zone 13, and a generation zone 14 placed between the heating zone 12 and the cooling zone 13. An inner tube 11a in the preheating zone 11, an inner tube 12a in the heating zone 12, an inner tube 13a in the cooling zone 13, and an inner tube 14a in the generation zone 14 are joined with each other. An endless belt 15 is continuously passed through the inner tubes 11a, 12a, 13a and 14a.

The preheating zone 11, the heating zone 12, the cooling zone 13 have the same structures as of the conventional mesh belt-type furnace as shown in Fig. 1. The generation zone 14 is constructed such that thermoelectric conversion modules 14b are mounted around the inner tube 14a. A reducing gas is in the inner tubes 11a, 12a, 13a and 14a.

Since the generation zone 14 including the inner tube 14a is put between the heating zone 12 and the cooling zone 13 as described the above, the generation efficiency of the thermoelectric conversion modules 14b is increased. As shown in Fig. 3, two generation zones, that is, a generation zone 14 and a generation zone 15, can be disposed between the heating zone 12 and the cooling zone 13. For example, thermoelectric conversion modules 14b and 15b are mounted around the inner tubes 14a and 15a. As a result, the generation efficiency of the thermoelectric conversion modules 14b and 15b can be thereby further increased. In this case, the thermoelectric conversion module 14b of the higher temperature side can have SiGe elements, and the thermoelectric conversion module 15b of the lower temperature side can have PbTe elements. The SiGe element exhibits the highest generation performance at about 830°C, and the PbTe element exhibits the highest generation performance at about 400°C. Therefore, the SiGe element can efficiently generate electricity in a temperature range from 450°C to 900°C in accordance with the temperature of the cooling zone 13 of the furnace, and the PbTe element can efficiently generate electricity in a temperature range from 200°C to 450°C in accordance with the temperature of the cooling zone 13 of the furnace.

The thermoelectric conversion modules used in the generation zones 14 and 15 shown in Figs. 2 and 3 will be specifically described hereinafter.

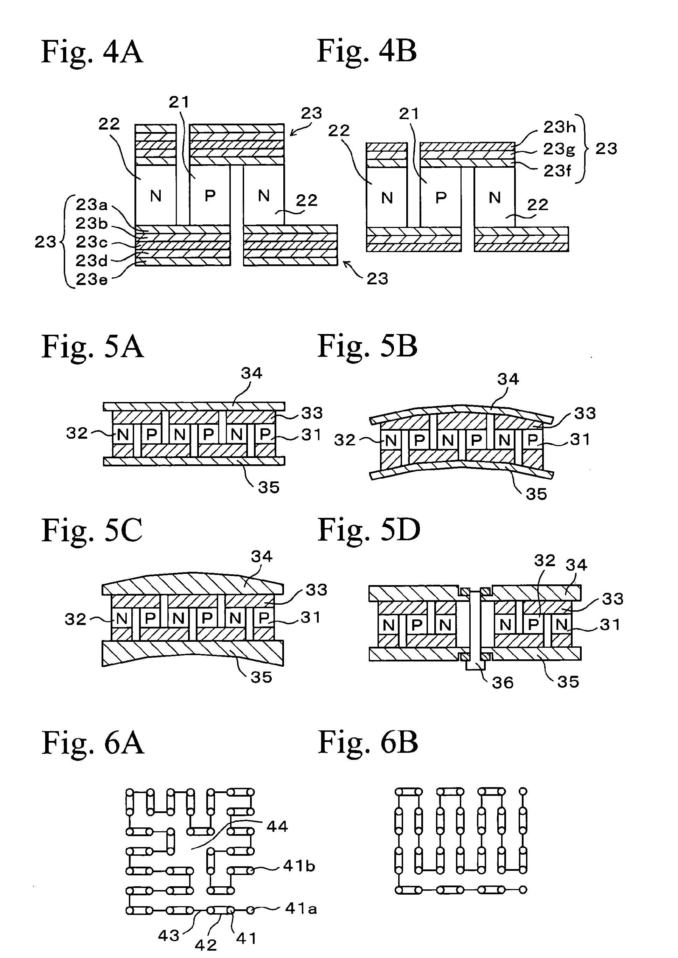

Figs. 4A and 4B are cross sectional views showing a part of a thermoelectric conversion module in one embodiment according to the present invention. The thermoelectric conversion modules as shown in Figs. 4A and 4B have P-type thermoelectric conversion elements 21, N-type thermoelectric conversion elements 22, and connecting pads 23 connecting the elements 21 and 22 to each other. Copper plates (not shown) are fixed to the outside of the connecting pads 23.

The connecting pads 23 connect the elements 21 and 22, and insulate electrically and conduct thermally between the thermoelectric conversion elements and the copper plates. The connecting pads 23 shown in Figs. 4A and 4B can be produced by multi-layered powder compacting and by sintering.

As shown in Fig. 4A, the connecting pads 23 are constructed such that a copper layer 23a, a mixed layer 23b of a copper and an alumina, an alumina layer 23c, a mixed layer 23d of a copper and an alumina, and a copper layer 23e are laminated in turn on the side of the elements 21 and 22. On the other hand, as shown in Fig. 4B, the connecting pad 23 is constructed such that a copper layer 23f, a mixed layer 23g of a copper and an alumina, and an alumina layer 23h are laminated in turn on the side of the elements 21 and 22. The mixed layers 23b, 23d and 23g are mixed such that the ratio of a copper and an alumina is 1 to 1. Alternatively, the mixed layers 23b, 23d and 23g are such that the ratio of a copper and alumina is other than 1 to 1.

The layers 23a to 23h of the bonding pads 23 shown in Fig. 4A and 4B can be connected with each other via a bonding agent such as a binder. Alternatively, the layers 23a to 23h of the connecting pads 23 are simply laminated in turn and can be held by an appropriate joining device so as to be connected with each other. These above connecting techniques can be applied in order to prevent a slip between the alumina layer 27h and the copper plate (not shown) contacting the alumina layer 27h when the connecting pad 23 shown in Fig. 4B is constructed such that the alumina layer 23h is exposed. The copper plate is a heat receiving plate or a heat discharging member.

A mixed agent of a carbon-type material and a binder, a copper paste in which copper powder is dispersed on a silicate glass, or a silver paste in which silver powder is dispersed on a silicate glass can be used as the above bonding agent. When the mixed agent is used, a low melting point glass can be favorably used on the higher temperature side (the heat receiving plate side), and a resin-type material can be favorably used on the lower temperature side (the heat discharging plate side). The above binder has an adhering function of the respective members, a fixing function, a filling function of irregularities between the members, a thermal conducting function, and an electrical conducting function. The above binder can be selected in accordance with a category temperature and a binding position.

Figs. 5A to 5D are cross sectional views showing a favorable form of the thermoelectric conversion module in one embodiment according to the present invention. The thermoelectric conversion modules shown in Figs. 5A to 5D have P-type thermoelectric conversion modules 31, N-type thermoelectric conversion modules 32, connecting pads connecting the elements 31 and 32 which are close to each other, and copper plates 34 and 35 positioned on the outside of the connecting pads 33.

In an example shown in Fig. 5A, the thermoelectric conversion module is constructed such that the members 31 to 35 are integrated with each other by using a bonding agent and are completely mounted to the plane of the furnace in the later process. In an example shown in Fig. 5B, the thermoelectric conversion module is constructed such that the upper and bottom faces thereof have a cylindrically curved structure and are mounted to a cylindrically curved surface of the furnace. In this example shown in Fig. 5B, the connecting pad 33 has a curved form by powder compacting. In an example shown in Fig. 5C, the thermoelectric conversion module is constructed such that the upper and bottom faces thereof have a cylindrically curved structure in the same manner as the example shown in Fig. 5B. In this example shown in Fig. 5C, the copper plates 34 and 35 (a heat receiving plate or a heat discharging member) have a curved form by powder compacting. In an example shown in Fig. 5D, the thermoelectric conversion module is constructed such that the copper plates 34 and 35 are fastened with a bolt 36. In this example shown in Fig. 5D, a gap is easily generated among the thermoelectric conversion elements 31 and 32 and the connecting pad 33 as these members 31, 32, and 33 are disposed away from the bolt 36. Therefore, a bonding agent is desirably applied as a filler to fill the gaps among these members 31, 32, and 33.

Figs. 6A and 6B are upper face views showing an example of a connecting line of the thermoelectric conversion modules shown in Figs. 5A to 5D. In an example shown in Fig. 6A, 47 thermoelectric conversion elements are connected in series by heating side connection lines 42 and cooling side lines 43. In this example shown in Fig. 6A, a thermoelectric conversion element 41a and a thermoelectric conversion element 41b can be as an output terminal. This example shown in Fig. 6A can be applied to the examples shown in Figs. 5A to 5C. A case in which a bolt is positioned in a space portion 44 shown in Fig. 6A corresponds to the example shown in Fig. 5D. The surface copper layers of the connecting pads are used as connecting lines in the thermoelectric conversion module. As described the above, the output terminals of the thermoelectric conversion modules are connected with each other. In this case, the electricity generated by the thermoelectric conversion modules is output to a storage battery via a converter or is output to an auxiliary device such as lighting via a transformer. In the other example shown in Fig. 6B, 42 elements 41 are connected in series.

The above examples are desirable thermoelectric conversion modules of the present invention. Desirable examples of tunnel-type furnaces having the thermoelectric conversion modules of the present invention will be described hereinafter.

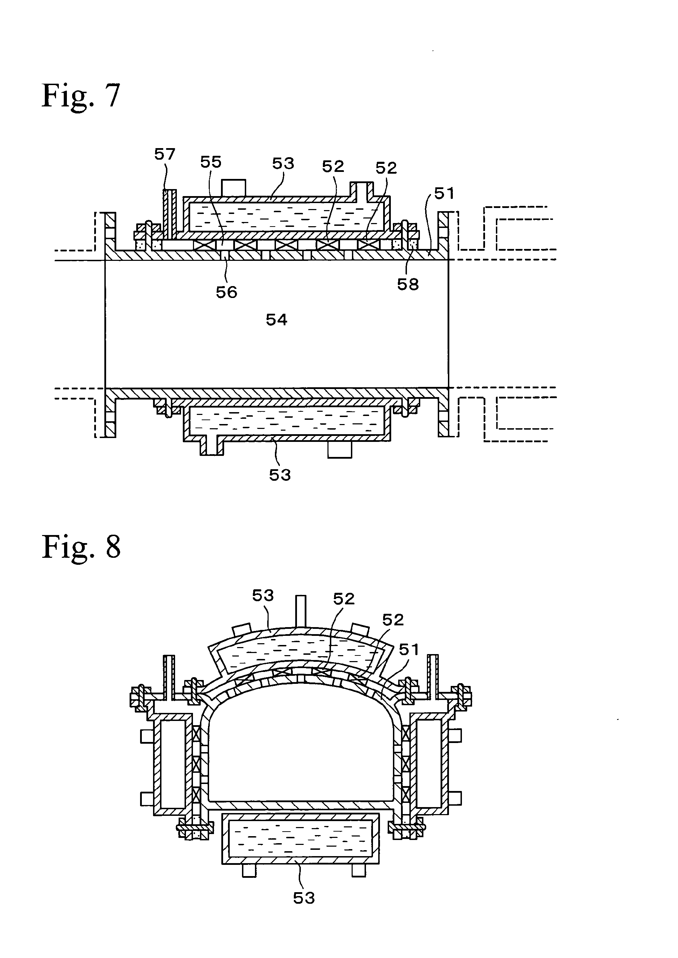

Fig. 7 is a cross sectional view showing an example of a generation zone of the tunnel-type furnace. This generation zone is equipped with an inner tube 51, plural thermoelectric conversion modules 52, and a water jacket 53. The plural thermoelectric conversion modules 52 are disposed at at least a part of the outer face of the inner tube 51 so as to be disposed away from each other. That is, as shown in Fig.7, the plural thermoelectric conversion modules 52 are disposed at the upper portion and both side portions (not shown) of the outer face of the inner tube 51. The water jacket 53 covers the plural thermoelectric conversion modules 52. In this generation zone, a space 55 is formed between the inner tube 51 and the water jacket 53, plural holes 56 are formed so as to communicate from the inner tube 51 to the space 55, and a gas discharging tube 57, which communicates from the space 55 to an outside, is formed so that a non-oxidizing gas is flowed from the inside 54 of the inner tube 51 to the outside via the space 55. A seal 58 is provided between the inner tube 51 and the bottom plate of the water jacket 53 so as to form a seal therebetween. The above non-oxidizing gas is desirably hydrogen or a mixed gas of a hydrogen gas and a nitrogen gas. The mixed gas includes a dissociated ammonia gas.

In the above structure of the tunnel-type furnace shown in Fig. 7, the temperature of the inner tube 51 increases by the heat of the work which is heated on the endless belt (not shown). The one ends of the thermoelectric conversion modules 52 are heated by the heat of the inner tube 51 gained by the temperature rise. The other ends of the thermoelectric conversion modules 52 are cooled by the water jacket 53. As a result, the thermoelectric conversion modules 52 generate electricity based on the Seebeck effect in accordance with the above temperature differences between the one ends and the other ends of the thermoelectric conversion modules 52. The thermoelectric conversion modules 52 have a relatively high temperature during the use of the furnace. The temperature is so high that the thermoelectric conversion modules 52 are oxidized in the air. However, the thermoelectric conversion modules 52 are prevented from being oxidized and being deteriorated since the non-oxidizing gas is flowed in gaps which are formed among the thermoelectric conversion modules 52 which are next to each other and are formed among the elements of the thermoelectric conversion modules 52, which are next to each other. The combustion disposal is performed on the non-oxidizing gas discharged to the outside.

Fig. 8 is a axial sectional view of the generation zone shown in Fig. 7. The respective members of the generation zone are placed and fixed as follows. For example, the inner tube 51 is placed such that predetermined faces thereof are directed upward, the thermoelectric conversion modules 52 are mounted to the predetermined faces via bonding agents such as copper pastes coated thereon, and are connected with each other. Next, bonding agents are coated on the copper plates placed on the top faces of the thermoelectric conversion modules 52, and then the water jacket 53 is mounted thereto and is fastened by bolts. The above operations are performed in turn on predetermined faces of the inner tube 51, on which the thermoelectric conversion modules are planned to be provided. The above bonding agents may have thermo-plastic properties and can be used as they are. The above bonding agents are used for filling the gaps formed in the contacted portions of the respective members and for improving thermal conductivities thereof. The above bonding agents are therefore of a carbon-type, are favorably of a copper-type, and are more favorably of a silver-type. The generation zone assembled in the above manner is used by connecting zones (shown as dotted portions), which are next to the inner tube 51. The above tunnel-type furnace is one example, and the respective members thereof can be arranged and fixed in various manners other than the above manner.

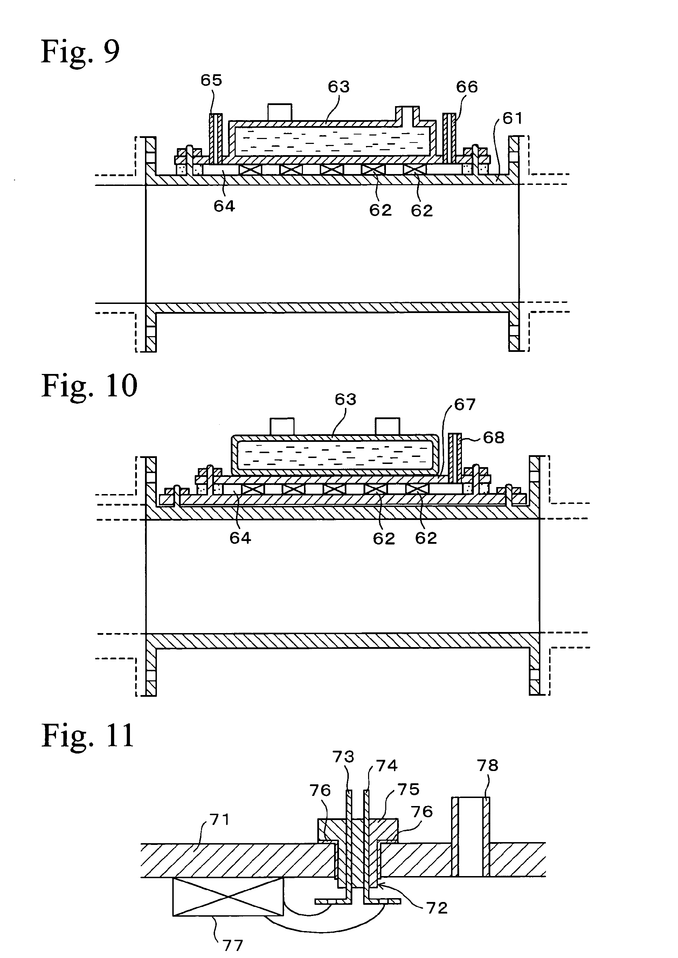

Fig. 9 is a cross sectional view showing another example of a generation zone of the tunnel-type furnace. This generation zone is equipped with an inner tube 61, plural thermoelectric conversion modules 62, and a water jacket 63. The plural thermoelectric conversion modules 62 are disposed at at least a part of the outer face of the inner tube 61 so as to be away from each other. That is, as shown in Fig.9, the plural thermoelectric conversion modules 62 are disposed at the upper portion and both side portions (not shown) of the outer face of the inner tube 61. The water jacket 63 covers the plural thermoelectric conversion modules 62. In this generation zone, a space 64 is formed between the inner tube 61 and the water jacket 63. A gas supplying tube 65 and a gas discharging tube 66, which communicate from an outside to the space 64, are formed so that a non-oxidizing gas is flowed from the outside to the outside via the space 64.

In the above structure of the tunnel-type furnace, even when the inside of the inner tube 61 is under an oxidizing gas such as the air, the thermoelectric conversion modules 62 are prevented from being oxidized and being deteriorated since the non-oxidizing gas is in the space 64 which is isolated from the inside of the inner tube 61.

Fig. 10 is a cross sectional view showing another example of a generation zone of the tunnel-type furnace. This example shown in Fig. 10 is a variation of the tunnel-type furnace shown in Fig. 9. This example is different from the generation zone as shown in Fig. 9 in that the thermoelectric conversion modules 62 and the water jacket 63 are removably provided to each other. That is, the thermoelectric conversion modules 62 are not directly connected to the bottom portion of the water jacket 63, and a dividing member 67 is separately mounted between the members 62 and 63.

In the above structure of the tunnel-type furnace, it is easy to assemble and repair the thermoelectric conversion modules 62 and the water jacket 63. Since gaps are easily formed among the thermoelectric conversion modules 62 and the water jacket 63 when these members 62 and 63 are assembled, bonding agents such as copper pastes are favorably coated thereon. In this example, a vacuum pump (not shown) is connected to a gas tube 68, and the space 64 can be degassed by the vacuum pump so that the pressure thereof is reduced, instead of circulating the non-oxidizing gas in the space 64 in which the thermoelectric conversion modules 62 are provided.

Fig. 11 is a cross sectional view showing a structure for outputting electricity generated in the various structures of generation zones shown in Figs. 7 to 10. The structure for outputting electricity is as follows. For example, a hole 72 penetrates a cooling plate 71 contacting the water jacket. An insulator member 75 of a ceramic is mounted to the hole 72 via a seal member 76. Positive and negative copper lines 73 and 74 are embedded in insulator member 75. The positive and negative copper lines 73 and 74 are connected so that electricity generated by a thermoelectric conversion module 77 is led to an outside. When a thermoelectric conversion module 77 is in a degassed decompressed state, and a vacuum pump connecting opening 78 is favorably provided as shown in Fig. 11.

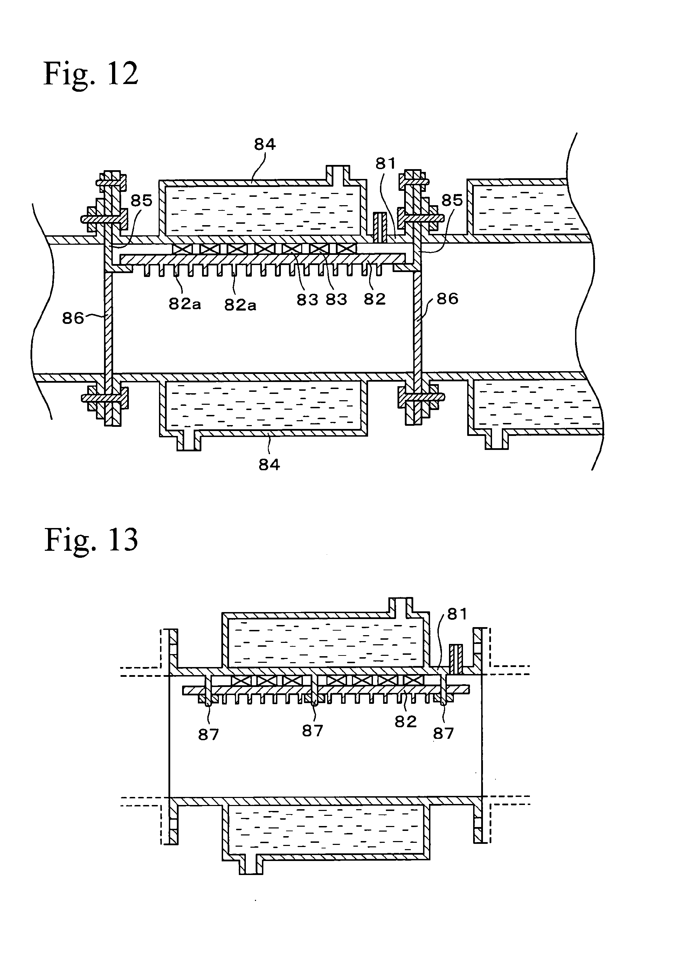

Fig. 12 is a cross sectional view showing another example of a generation zone of the tunnel-type furnace. This example shown in Fig. 12 is a variation of the tunnel-type furnace shown in Figs. 7 and 8. This generation zone is equipped with an inner tube 81, a heat receiving member 82, plural thermoelectric conversion modules 83, and a water jacket 84. The heat receiving member 82 is provided in the inner tube 81. The plural thermoelectric conversion modules 83 are disposed between at least a part of the inner face of the inner tube 81 and the heat receiving member 82 so as to be away from each other. The part of the inner face of the inner tube 81 has the upper portion and both side portions (not shown) of the inner face of the inner tube 81. The water jacket 84 covers the plural thermoelectric conversion modules 83 in accordance with the provided positions of the thermoelectric conversion modules 83. This generation zone has a structure such that a non-oxidizing gas is flowed in the inner tube 81.

In this structure of the example of the generation zone as shown in Fig. 12, the thermoelectric conversion modules 83 can be prevented from being oxidized by the atmosphere gas in the tunnel-type furnace in the same manner as the generation zone shown in Figs. 7 and 8. This example has the following structure. That is, the thermoelectric conversion modules 83 are provided in the inner tube 81. The heat receiving member 82 prevents the thermoelectric conversion modules 83 from falling therefrom. The heat receiving member 82 receives heat. The heat receiving member 82 is favorably made of copper, and has plural fins 82a as shown in Fig. 12 so as to have good heat receiving properties.

The respective members of the example of the generation zone are assembled as follows. For example, the inner tube 81 is placed such that predetermined faces thereof are directed downward, and the thermoelectric conversion modules 83 are mounted to the predetermined faces via bonding agents such as copper pastes. Next, the thermoelectric conversion modules 83 are covered with the heat receiving member 82, and a wedge is driven by using a rod in the heat receiving member 82 and the inner face of the inner tube 81 facing the heat receiving member 82 so that the heat receiving member 82 is prevented from moving. Finally, the heat receiving member 82 is fixed by using fixing angle members 85 with an appropriate strength, and the rod is removed therefrom. The above operations are performed in turn on predetermined faces of the inner tube 81, which the thermoelectric conversion modules83 are planned to be provided. Heat resistant sheets 86 are provided among the fixing angle members 85. The generation zone assembled in the above manner is used for connecting zones, which are next to the inner tube 81 as shown in Fig. 12.

Fig. 13 is a cross sectional view showing another example of a generation zone of the tunnel-type furnace. This example shown in Fig. 13 is a variation of the tunnel-type furnace shown in Fig. 12. This example is different from the generation zone shown in Fig. 12 in that the heat receiving member 82 is fastened by bolts 87 welded to the inner tube 81. This example can yield the same effects as the example shown in Fig. 12.

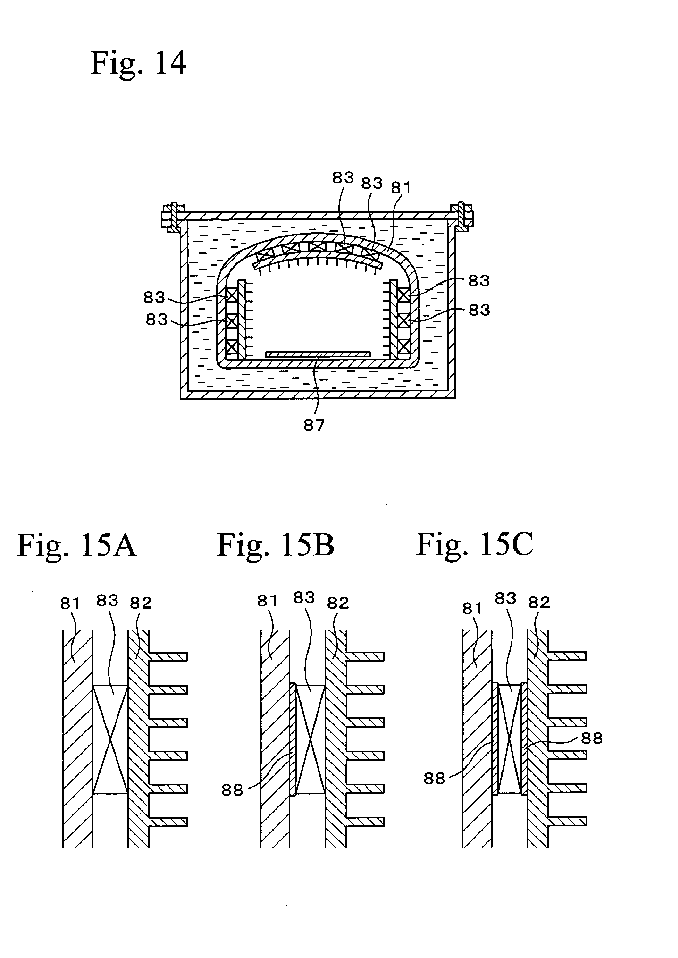

Fig. 14 is an axial sectional view showing a connected form of the generation zone shown in Fig. 12 and 13. As shown in Fig. 14, plural thermoelectric conversion modules 83 are provided to the upper curved face and both side faces of the inner tube 81, and an endless belt 87 is passed on the lower side face thereof.

Figs. 15A to 15C are cross sectional views showing a part of the connected form of the generation zone shown in Fig. 14. In the example shown in Fig. 15A, no bonding agent is used for connecting the inner tube 81, plural thermoelectric conversion modules 83, and the heat receiving member 82. In the example shown in Fig. 15B, a bonding agent 88 is used only for connecting the inner tube 81 and the thermoelectric conversion module 83. In the example shown in Fig. 15C, bonding agents 88 are used for connecting the inner tube 81 and the thermoelectric conversion module 83 and for connecting the thermoelectric conversion module 83 and the heat receiving member 82. In these above examples, the bonding agents can be appropriately selected. In a case in which the provided face is large and is not smooth and/or in a case the inner tube 81 which does not have a good surface state is connected thereto, gaps are filled by using bonding agents so as to improve thermal conductivity therein.

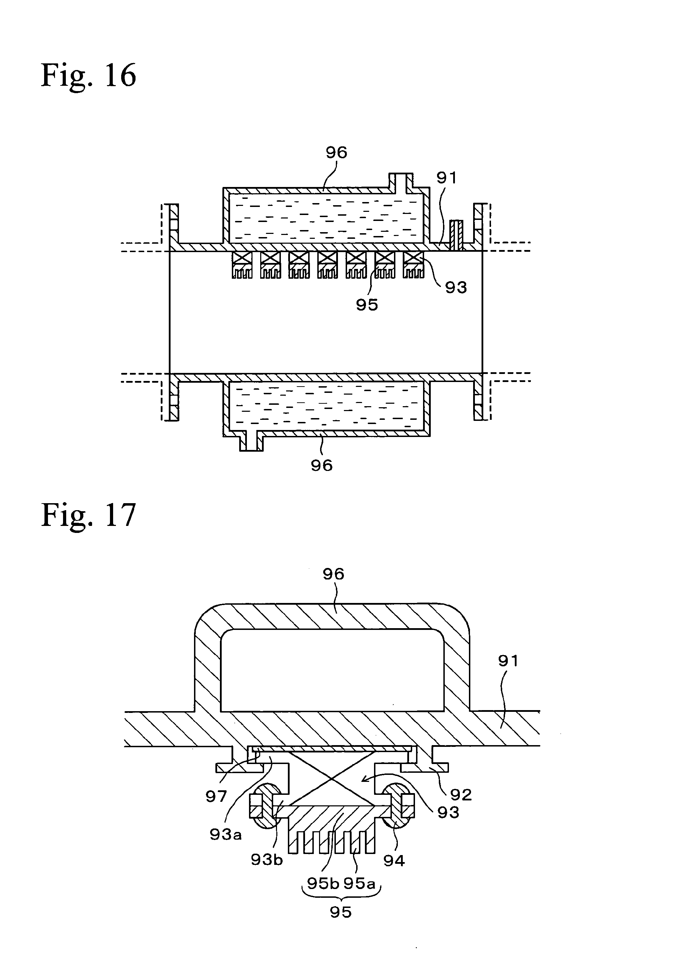

Fig. 16 is a cross sectional view showing another example of a generation zone of the tunnel-type furnace. Fig. 17 is a cross sectional view showing the detail of a mounted structure of respective members shown in Fig. 16. As shown in Figs. 16 and 17, this generation zone is equipped with an inner tube 91, hooks 92, plural thermoelectric conversion modules 93, rivets 94, a heat receiving member 95, and a water jacket 96. The hooks 92 have a T-shaped portion in a cross section thereof, and are connected to the inner tube 91. The thermoelectric conversion modules 93 are supported by the hooks 92 at at least a part of the inner face of the inner tube 91 so as to be away from each other. The part of the inner face of the inner tube 91 has the upper portion and both side portions (not shown) of the inner face of the inner tube 91. The heat receiving member 95 is fastened by the rivets 94 at sides of the thermoelectric conversion modules 93. The sides of thermoelectric conversion modules 93 are opposite to the inner tube 91. The water jacket 96 covers the inner tube 91 in accordance with the provided positions of the thermoelectric conversion modules 93. This generation zone has a structure such that a non-oxidizing gas is flowed in the inner tube 91.

The respective members of the example of the generation zone are assembled as follows. For example, first, the hooks 92 having a T-shaped portion in a cross section are welded in the inner tube 91, and bonding agents 97 are coated on a predetermined face of the inner tube 91. Next, the thermoelectric conversion module 93 is mounted so as to be fitted into a recessed portion between the hooks 92, and is screwed thereto. In this case, copper plates 93a and 93b of the thermoelectric conversion module 93 are broadened. Copper plate main body portions 95b of the heat receiving member 95 having plural fins 95a and the outside copper plates 93b of the thermoelectric conversion modules 93 are fastened by the rivets 94 to each other.

According to the tunnel-type furnaces equipped with a generation zone as shown in Figs. 7, 9, 10, 12, 13, and 16, the heating zone has thermal insulation by providing bricks, etc., to the heating zone, and the generation zone is provided between the heating zone and the cooling zone, whereby the thermoelectric conversion module can have good thermal efficiency. The above thermoelectric conversion module can be provided to the outer face of the tunnel-type furnace, and the tunnel-type furnace thereby facilitates the maintenance thereof. In the above tunnel-type furnaces, the thermoelectric conversion modules can be provided to the outer face of the tunnel-type furnace, and thermal stress relieving members can be used as a component member of the thermoelectric conversion module. As a result, the thermoelectric conversion module can be prevented from being peeled and falling from the tunnel-type furnace during the operation of the tunnel-type furnace. Since the non-oxidizing gas is charged in the space, there is no possibility that the thermoelectric conversion module may be oxidized and may be deteriorated during the operation of the tunnel-type furnace. Therefore, the tunnel-type furnace can have long-term stable performance.

In the tunnel-type furnace equipped with a generation zone as shown in Figs. 7, 9, 10, 12, 13, and 16, when the thermoelectric conversion elements of the thermoelectric conversion module have SiGe elements, the respective thermoelectric conversion elements can yield an output of 5W. As a result, when two thousand SiGe elements are used, the generation zone can be expected to yield an output of 10 kW in total, and can yield an approximate output of 61,300 kWh in a year. The generated electricity can be used for lighting a work environment, for operating a control temperature measurement device, etc., and for driving a motor which is for re-cooling cooling water of which the temperature rose after being discharged from the furnace.

## Claims

1. A thermoelectric energy conversion unit comprising:
a thermoelectric conversion module having plural thermoelectric conversion elements disposed away from each other;
a heat receiving member;
a cooling member, the cooling member and the heat receiving member holding the thermoelectric conversion module; and
a non-oxidizing gas charged in a space formed between the heat receiving member and the cooling member.

2. A tunnel-type furnace comprising:
a heating zone;
a cooling zone, wherein heated bodies are transferred in turn in the heating zone and the cooling zone; and
a thermoelectric energy conversion unit provided between the heating zone and the cooling zone,
the thermoelectric energy conversion unit comprising:
thermoelectric conversion modules having plural thermoelectric conversion elements disposed away from each other;
a heat receiving member;
a cooling member, the cooling member and the heat receiving member holding the thermoelectric conversion module; and
a non-oxidizing gas charged in a space formed between the heat receiving member and the cooling member.

3. The tunnel-type furnace according to claim 2, wherein the furnace further comprising:
an inner tube in which the heated bodies are transferred;
a cooling device covering the thermoelectric conversion modules;
plural holes provided in at least a part of the inner tube, the plural holes communicating from an inside of the inner tube to a space formed between the inner tube and the cooling device; and
a gas discharging portion communicating from the space to an outside,
wherein the thermoelectric conversion modules are disposed at at least on a part of the outer face so as to be away from each other, and
the non-oxidizing gas is flowed from the inside of the inner tube to the outside via the space.

4. The tunnel-type furnace according to claim 2, wherein the furnace further comprising:
an inner tube in which the heated bodies are transferred;
a cooling device covering the thermoelectric conversion modules;
a gas supplying portion; and
a gas discharging portion, the gas discharging portion and the gas supplying portion communicating from an outside to a space formed between the inner tube and the cooling device,
wherein the thermoelectric conversion modules are disposed so as to be away from each other at least at a part of the outer face of the inner tube, and
the non-oxidizing gas is flowed from the outside to the outside via the space.

5. The tunnel-type furnace according to claim 4, wherein the thermoelectric conversion modules and the cooling device are removably provided to each other.

6. The tunnel-type furnace according to claim 2, wherein the furnace further comprising:
an inner tube in which the heated bodies are transferred; and
a cooling device covering the thermoelectric conversion modules in accordance with provided positions of the thermoelectric conversion modules,
wherein the heat receiving member is provided in the inner tube, the thermoelectric conversion modules are held between at least a part of the inner face of the inner tube and the heat receiving member provided in the inner tube, and
the non-oxidizing gas is charged in the inner tube.

7. The tunnel-type furnace according to claim 6, wherein the furnace further comprising:
fixing angle members connected to the inner tube, the fixing angle members supporting the heat receiving member.

8. The tunnel-type furnace according to claim 6, wherein the furnace further comprising:
bolts welded to the inner tube, the bolts used for fastening the heat receiving member.

9. The tunnel-type furnace according to claim 2, wherein the furnace further comprising:
an inner tube in which the heated bodies are transferred;
a cooling device covering the inner tube in accordance with the provided positions of the thermoelectric conversion modules;
hooks connected to the inner tube; and
rivets for fastening the heat receiving member,
wherein the heat receiving member is fastened by the rivets at sides of the thermoelectric conversion modules, the sides of the thermoelectric conversion modules being opposite to the inner tube,
the thermoelectric conversion modules are supported by the hooks at at least a part of the inner face of the inner tube so as to be disposed away from each other, and
the non-oxidizing gas is charged in the inner tube.

10. The tunnel-type furnace according to one of claims 6 to 9, wherein the furnace further comprising:
plural fins provided at the heat receiving member.
